# EUROPEAN PATENT APPLICATION

(11) **EP 3 396 706 A1**
(43) Date of publication of application: **31.10.2018**
(21) Application number: 18000389.9
(22) Date of filing: 23.04.2018
(51) Int. Cl.: H01L 21/66, B23K 26/03, G01N 21/958

(54) **SUBSTRATE CUTTING CONTROL AND INSPECTION**

(30) Priority: 26.04.2017 US 201715497754
(71) Applicant: ASM Technology Singapore Pte Ltd., Singapore 768924 (SG)
(72) Inventor: KNIPPELS, Guido, 5481 RA Schijndel (NL); VAN DER STAM, Karel Maykel Richard, 7314 HD Apeldoorn (NL); SUBKHANGULOV, Ruslan Rifovich, 6546 JT Nijmegen (NL)
(74) Representative: Griebling, Onno

(57) **Abstract**

A wafer substrate is inspected by illuminating it on both sides, and imaging light which has both been reflected from and transmitted through the substrate. The substrate is supported on a stage, and first and second illumination sources are arranged to respectively illuminate the first surface of the substrate supported by the stage and to illuminate the second surface of the substrate supported by the stage in use. At least one camera is adapted to image light received from the substrate when it is illuminated by the first illumination source and/or the second illumination source. Inspection may occur during a cutting process.

## Description

This invention relates to inspection system, substrate cutting apparatus, a method of inspecting a substrate, and a substrate cutting process.

### Background and Prior Art

Dicing and grooving are well-known processes in the semiconductor industry, in which a cutting machine is used to work a workpiece or substrate such as a semiconductor wafer, which could for example comprise silicon but is not so limited. Throughout this specification, the term "substrate" is used to encompass all these products. Mechanical cutting machines, for example using a circular saw, have conventionally been used for this, while more recently laser cutting machines have become widespread, which machines generate and direct one or more laser beams (for example an array of laser beams) onto a substrate. In laser dicing (also referred to as laser singulation, severing, cleaving for example), one or more laser beams are used to completely cut through a substrate such as to singulate the substrate into individual dies. In laser grooving (also referred to as laser scribing, scoring, gouging or furrowing for example), one or more laser beams are used to cut a channel or groove into a substrate. Other processes may be applied subsequently, for example full singulation by using a physical saw along the laser-cut channels. Throughout the present specification, the term "laser cutting" will be used to encompass both laser dicing and laser grooving.

For laser cutting, i.e. both laser dicing and laser grooving, control of the cutting process takes place in two ways:
1) The input parameters, e.g., laser power, laser frequency etc., are well-controlled by the laser cutting machine, and
2) The result of the laser process is checked with an imaging system inside the laser cutting machine, or by removing the substrate from the machine and inspecting the result on a separate inspection tool, such as a microscope or 3-D profiler.

The input parameters of the laser process can be controlled very accurately. Currently however, inspecting the result of the laser process has significant limitations. Removing the substrate from the machine for separate inspection enables high quality inspection, but is both time and resource intensive, and as such is only appropriate for testing or periodic quality control. During production, fast, in-line inspection is required.

With current machines, inspection is generally performed by illuminating the substrate from above and then using a camera to obtain an image of the reflection from the substrate surface. The camera image is then inspected. This method has several limitations however, for example:
1) The image quality is limited by the presence of contamination on the substrate surface that is created during the laser cutting process. The substrate could of course be cleaned before each inspection, but that would reduce the productivity tremendously;
2) The imaging technique is only sensitive for the top surface of the substrate. No information about the substrate material is obtained; and
3) The imaging technique has limitations in following large deviations in the topology. Deep narrow kerfs for example cannot be detected accurately.

Known prior art that may be mentioned by way of background are: US-B2-7494900, US-B2-9266192, US-A1-2011/0132885 and US-A1-2013/0329222.

It is an aim of the present invention to overcome these problems and enable higher quality inspection. This inspection may for example be performed during a cutting operation.

In accordance with the present invention, this aim is achieved by providing illumination both from below and above the substrate, i.e. so that light is incident both upon the lower external surface and the upper external surface of the substrate. Advantageously, images may then be obtained using light transmitted through the substrate, as well as reflected therefrom.

As noted above, the substrate is illuminated from below. The wavelength of this illumination could be specific for the substrate material (absorption should be not too high) or a broad-band illumination like 'white light' could be used. The illumination source could be a single point source, for example when the substrate is mounted on a transparent stage, but in one preferred realisation the illumination source is integrated within the stage. Since every point on the substrate should be imaged, the stage may be equipped with, for example, an array of individual sources such as LEDs which can be controlled individually to prevent excessive heating (noting that ideally only the point which is laser processed should be inspected and illuminated). In an alternative preferred realisation, a transparent or translucent stage may be illuminated from the side, for example by a laser, with scattering within the stage causing light to exit from the top of the stage.

Using such techniques, all required cutting process criteria can be measured "on the fly", i.e. during the cutting process, including the determination of: groove width, groove / kerf position, groove / kerf depth and the remaining mold.

With the addition of a feedback loop the process can be tuned automatically, based on the "on the fly" measurements.

The preferred system provides optics to image the transmitted light on a camera. Where the illumination from below is broad-band, a filter can be applied to increase the signal to noise ratio.

During the laser cutting process, the removed material (i.e. the laser groove or laser dicing kerf) will be visualized by an increase of the transmitted light due to the local reduction of substrate thickness. By imaging the transmitted light on a camera, the absorption pattern of the substrate can be visualized. This absorption pattern therefore provides real-time information of the laser process, and the depth, width and position of the laser kerf can be obtained from this camera image.

The methods described herein can also be used to enable substrate alignment. This may be particularly useful in situations where the top surface of the substrate does not contain sufficient information for accurate substrate positioning, such as may be the case for memory wafers, molded wafers for example.

### Summary of the Invention

In accordance with a first aspect of the present invention there is provided an inspection system for inspecting a substrate, the substrate being substantially planar and having first and second major surfaces on opposite sides thereof, the inspection system comprising:
a stage for supporting the substrate in use,
a first illumination source arranged to illuminate the first surface of the substrate
supported by the stage in use,
a second illumination source arranged to illuminate the second surface of the substrate
supported by the stage in use, and
at least one camera adapted to image light received from the substrate when it is illuminated by the first illumination source and/or the second illumination source.

The system may comprise first and second cameras, the first camera being positioned to receive light from the first illumination source reflected from the first surface and the second camera being positioned to receive light from the second illumination source transmitted through the substrate. The first and second cameras may both be positioned on the first side of the substrate.

The first and second illumination sources may be arranged to emit light at respective frequency ranges, the first and second frequency ranges being non-identical.

The first illumination source may be arranged to emit ultraviolet light in use, with a wavelength in the range from about 10 nm to about 400 nm. Alternatively, the first illumination source may be arranged to emit light with a wavelength in the range from about 10 nm to about 400 nm.

The second illumination source may be arranged to emit broad-band wavelength light in use. With this embodiment, a filter may be provided in the optical path of the broad-band light.

The second illumination source may be arranged to emit infrared light in use, with a wavelength in the range from about 600 nm to about 2000 nm.

The stage may be transparent or translucent. The second illumination source may be arranged externally to the stage, such that it illuminates the second surface of the substrate following transmission of its emitted light through the stage. The stage may comprise an upper surface on which the substrate is supported in use, and a lower surface, opposite the upper surface, which lower surface is internally reflective to light from the second illumination source. The stage may comprise at least one sidewall which is internally reflective to light.

The or each internally reflective surface may comprise a mirrored surface.

The second illumination source may be operative to illuminate a side portion of the stage in use. The second illumination source may comprise a laser. The system may comprise an optical direction system operative to guide light emitted from the second illumination source to the side portion in use.

The second illumination source may be mounted within the stage. The stage may comprise:
a surface for supporting the substrate thereon in use,
a cavity within the stage,
wherein the second illumination source is mounted within the cavity such that light emitted by the second illumination source escapes the cavity and is incident upon the substrate in use.

In this case, the surface may comprise a transparent window on a first side of which the substrate is supported in use, the cavity being located adjacent a second side of the window, opposite to the first side. The surface may comprise an opening below the supported substrate in use, the opening leading to the cavity.

The second illumination source may comprise an array of light sources. The light sources of the array may be individually controllable.

In accordance with a second aspect of the present invention there is provided a substrate cutting apparatus comprising an inspection system according to the first aspect and a substrate cutting means.

The substrate cutting means may comprise a mechanical cutter. Alternatively, the substrate cutting means may comprise a laser cutter. In this case, the apparatus may comprise control means for controlling the laser cutter, the control means operable to receive image information from the first and second cameras and control the laser cutter in dependence of the received image information.

In accordance with a third aspect of the present invention there is provided a method of inspecting a substrate, the substrate being substantially planar and having first and second major surfaces on opposite sides thereof, the method comprising the steps:
i) illuminating the first surface of the substrate,
ii) illuminating the second surface of the substrate, and
iii) imaging light received from the substrate.

Advantageously steps i), ii) and iii) are performed simultaneously, preferably during cutting of the substrate, to improve efficiency, reduce processing time and enable "on-the-fly" processing.
Step iii) may comprise using first and second cameras to image the received light, the first camera being positioned to receive light from a first illumination source reflected from the first surface and the second camera being positioned to receive light from a second illumination source transmitted through the substrate.
Step ii) may comprise illuminating at least an area of a sidewall of a transparent or translucent stage on which the substrate is supported.
Step i) may comprise illuminating the first surface of the substrate with light at a first frequency range, while step ii) comprises illuminating the second surface of the substrate with light at a second frequency range, and wherein the first and second frequency ranges are non-identical.

The cutting operation may be a laser cutting operation. Alternatively, the cutting operation may be a substrate grooving operation. Alternatively, the cutting operation may be a substrate dicing operation. Alternatively, the cutting operation may be a substrate mold dicing operation.

The method may further comprise the step of:
iv) aligning the substrate using received light from the illumination performed in step ii).

In accordance with a fourth aspect of the present invention there is provided a substrate cutting process comprising performing the substrate inspection method of the third aspect.

There is also described a stage for supporting a substrate during a substrate cutting process which comprises:
a surface for supporting the substrate thereon in use,
a cavity within the stage,
an illumination source mounted within the cavity such that light emitted by the illumination source escapes the cavity and is incident upon the substrate in use.

The surface may comprise a transparent window on a first side of which the substrate is supported in use, the cavity being located adjacent a second side of the window, opposite to the first side.

The surface may comprise an opening below the supported substrate in use, the opening leading to the cavity.

The illumination source may comprise an array of individual light sources. The light sources of the array may be individually controllable.

Also described is a stage for supporting a substrate which comprises:
a transparent or translucent body,
the body having an upper surface for supporting a lower surface of the substrate thereon in use, and
a lower surface opposite to the upper surface,
wherein the lower surface is internally reflective to light.

The body may comprise at least one sidewall which is internally reflective to light.

The or each internally reflective surface may comprise a mirrored surface.

An inspection system may comprise such a stage and an illumination source, the illumination source operative to illuminate a side portion of the stage in use. The illumination source may comprise a laser. The inspection system may comprise an optical direction system operative to guide light emitted from the illumination source to the side portion in use.

The inspection system may comprise:
an upper illumination source arranged to illuminate an upper surface of the substrate supported by the stage in use, and
at least one camera adapted to image light received from the substrate.

Other specific aspects and features of the present invention are set out in the accompanying claims.

### Brief Description of the Drawings

The invention will now be described with reference to the accompanying drawings, in which:
FIG. 1A schematically shows an inspection system in accordance with a first embodiment of the present invention for use during a dicing operation;
FIG. 1B schematically shows a camera image taken during the dicing operation of FIG. 1A;
FIG. 2A schematically shows an inspection system in accordance with a second embodiment of the present invention for use during a grooving operation;
FIG. 2B schematically shows a camera image taken during the grooving operation of FIG. 2A;
FIG. 3A schematically shows an inspection system in accordance with a third embodiment of the present invention for use during a mold dicing operation;
FIG. 3B schematically shows a camera image taken during the mold dicing operation of FIG. 3A;
FIG.4 schematically shows an inspection system in accordance with a fourth embodiment of the present invention; and
FIG. 5 schematically shows an inspection system in accordance with a fifth embodiment of the present invention.

### Detailed Description of the Preferred Embodiments of the Invention

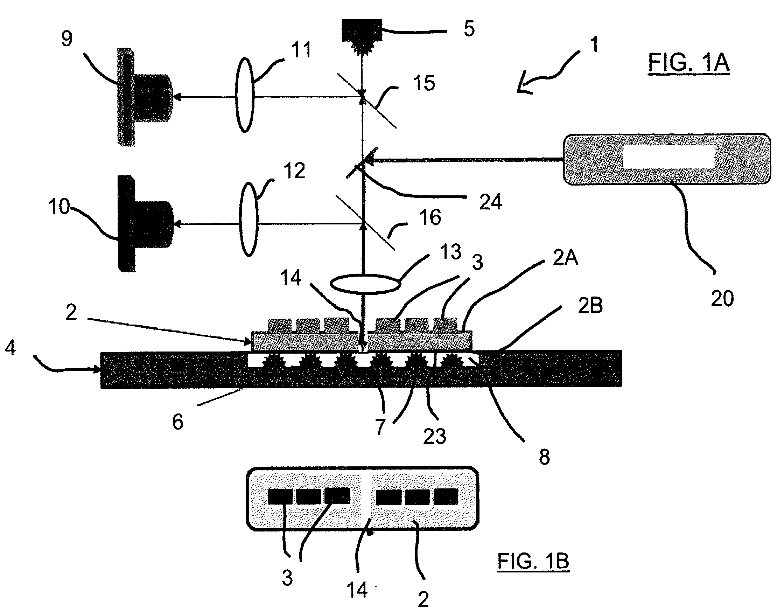

A first embodiment of the present invention will now be described with reference to FIGS. 1A and 1B, which respectively schematically show an inspection system 1 for use during a dicing operation, and a camera image taken during the dicing operation. FIG. 1A is a part-sectional view, in which cutting of the substrate occurs along the axis normal to the plane of the paper.

In this embodiment, inspection system 1 is used to inspect a dicing operation, in this embodiment a laser dicing operation, being performed on a silicon substrate (sometimes referred to as workpiece or wafer) 2. The substrate 2 is substantially planar with first 2A and second 2B major surfaces on opposite sides thereof. Substrate 2 has a number of devices 3 located on its top / first surface 2A. As is standard in the art, substrate 2 is provided with a dicing tape backing 23 adhered to the second surface 2B. The inspection system 1 forms a component part of a substrate cutting apparatus, which also includes laser cutting equipment. The laser cutting equipment comprises a cutting laser 20, which produces a beam incident upon guiding means, here a mirror 24, which directs the laser beam onto the substrate 2. Suitable laser cutting equipment is well-known in the art. With such equipment, one or more laser beams are directed onto a substrate to ablate all or part of the depth of the substrate. Although not shown for clarity in FIG. 1A, a diffractive optical element (DOE) may be placed in the path of the laser beam to produce a modified beam pattern for more efficient cutting.

The substrate 2 is supported in use on a chuck or stage 4. As is known in the art, the substrate 2 may be retained on the stage 4 using vacuum clamping (not shown). For a cutting operation to be performed, the substrate 2, and hence its supporting stage 4, must be moved relative to the or each laser cutting beam, so that a cut is made along a horizontal extent, i.e. the plane of the substrate. Since the laser set-up may be sensitive to movement, it is generally preferred to move the stage, and hence its supported substrate, in a horizontal direction while keeping the laser cutting equipment stationary. As such, drive means are provided to move the stage 4. For clarity, these drive means are omitted from FIG. 1A, however they are well-known the art. The inspection system 1 is located so as to follow the laser cutting equipment in the direction of stage movement, in other words so that it inspects a cut portion 14 of the substrate 2.

Above the substrate 2 there is provided a first, upper illumination source 5, operative to emit light at a first frequency range. In this embodiment, the first illumination source 5 emits light in the ultraviolet (UV) range, i.e. with wavelength in the range between about 10 nm and about 400 nm, preferably within the range 200 nm to 400 nm. The first illumination source 5 has an associated controllable electrical power source (not shown) located within the cutting apparatus, for providing operative electrical power thereto. As will be described below, the first illumination source 5 is arranged to illuminate the first surface 2A of the substrate 2.

In this embodiment, a UV laser may be used as the first illumination source, or alternatively a suitably collimated UV source such as a UV light-emitting diode (LED) array or lamp etc.

UV light from the first illumination source 5 passes sequentially through first and second beam splitters 15, 16, for example taking the form of one-way or partially-silvered mirrors, to a focusing lens 13. Focusing lens 13 focuses the UV light near the surface of the substrate 2. It should be noted that the UV light will be incident upon a cut area of the substrate, which by its nature may be of varying depth. As such the focusing by lens 13 must be suitable to cater for a range of depths. The UV light path is arranged to be substantially normal to the plane of the substrate 2. A significant proportion of the UV light incident upon the substrate 2 is reflected by the surface, so as to return back up through the focusing lens 13. The second beam splitter 16 is selected to be transparent to UV light, which therefore passes back through this second beam splitter, to the first beam splitter 15. The first beam splitter 15 is reflective to UV light, and is arranged so as to direct the reflected light towards a first, UV-sensitive, camera 9, via a first imaging lens 11. Image information from first camera 9 is passed for analysis to a separate control means (not shown), such as a processor or computer. Advantageously, this control means may also be operable to control the laser cutter of the substrate cutting apparatus in dependence of the received image information.

In addition to the above-described first illumination mechanism, the inspection system 1 also includes a second illumination mechanism, arranged to transmit light through the substrate 2, in this embodiment infrared (IR) light. A second illumination source 6, in this embodiment comprising an array of individual point sources, here LEDs 7, is mounted within a cavity 8 formed as a recess within the stage 4, its upper extent being an opening in the surface below the supported substrate in use. The LEDS 7 are located on the lower floor of the cavity such that light emitted from the array is directed generally upwards towards the opening and the substrate 2, so that the emitted light escapes the cavity 8. Dicing tape 23 is transparent to IR light, and so the IR light can pass through the tape to be incident upon the second surface 2B of the substrate 2 in use. The array is two-dimensional, such that at least one LED 7 is capable of illuminating the substrate 2 underside directly beneath any point along the or each cutting line. In alternative embodiments (not shown), a transparent window or cover may be located adjacent the cavity 8 to cover and close-off the cavity, and support the substrate 2 on a first, upper, side thereof, while permitting light to pass through, the cavity being located adjacent a second, lower, side of the transparent window, opposite to the first side. In yet further embodiments (not shown), the entirety of the cavity 8 may be filled with a transparent potting compound to protect the LEDs 7. An electrical power source (not shown) for the LEDs 7 is provided at a location within the cutting apparatus, so that electrical power can be fed to the LEDs via a power line from the source. Operation of the LEDs 7 can thus be controlled by suitable control of the incoming power, and the control means may advantageously individually control each of the LEDs 7 within the array. It should be noted that since stage 4 is movable, the power line must be configured to move with the stage, without risk of damage. In a suitable configuration, the power line comprises a long wire which communicated between the cavity 8 and the power source via a dedicated channel (not shown) formed within the stage 4.

In this embodiment, the second illumination source 6 is operative to emit infrared (IR) light, i.e. light with a wavelength within the range from about 600 nm to about 2000 nm, and it should be noted that the first and second illumination sources 5, 6 are therefore arranged to emit light at respective frequency ranges, the first and second frequency ranges being non-identical. Infrared light is highly suitable, since it can be transmitted through many types of workpiece. The actual range used may be chosen for the workpiece in question. Some suitable wavelength ranges for various substrate materials are set out in Table 1 below:

**Table 1**

| **Material** | **Optimum operating wavelength** | **Preferred operating wavelength range** | **Possible operating wavelength range** |
|---|---|---|---|
| Silicon | 850nm | 750nm - 850nm | 650nm - 2000nm |
| Mold compound | 980nm | 900nm - 1100nm | 600nm - 2000nm |
| GaAs | 800nm | 700nm - 900nm | 600nm - 2000nm |

A second camera 10, which is operative to image light transmitted from the second illumination source 6, is located on the same side of the substrate 2 as the first camera 9. During use, light emitted from the second illumination source passes through the substrate 2, is focused by lens 13, and then directed by second beam splitter 16 to the second camera 10 via a second imaging lens 12. It should be noted that for wavelengths up to about 1um, second camera 10 could comprise a standard IR camera. For longer wavelengths, an InGaAs camera may be preferred. Image information from second camera 10 is passed for analysis to the control means.

The operation of the inspection system of FIG. 1A will now be described. Initially, a substrate 2 having surface devices 3 is loaded onto stage 4 as is standard in the art, and held in position for example by vacuum clamping. Substrate 2 is aligned with the stage cavity 8, such that the entirety of the underside of substrate 2 below and along the intended cutting line is illuminable by the second illumination source 6. The stage 4 is moved horizontally such that the substrate 2 is illuminated and hence a groove 14 is cut by a stationary cutting laser beam produced by cutting laser 20, with the cutting line determined by the direction of movement of the stage 4 relative to the cutting laser beam. This being a dicing operation, at the end of the cutting process the substrate 2 will be completely cut through, however FIG. 1A shows an intermediate "snapshot" of the process, in which complete separation has not yet occurred. The inspection system follows the cutting, such that the effect of the cutting can be observed. The UV light path and its associated optics 5, 15, 13, 11 and 9 is used to inspect surface features of the substrate 2. Additionally, one or more LEDs 7 within the array of the second illumination source 6 are lit to illuminate a portion of the substrate underneath the focusing lens 13, and behind the cutting position, while second camera 10 images the received light which has passed through the substrate 2. Once the substrate 2 has moved on, those LEDs may be switched off, for example to reduce heating and power consumption, and adjacent LEDs 7 under the focusing lens 13 are turned on, and this sequence is repeated so that the substrate is constantly illuminated from below along the cutting line by at least one LED 7.

The image captured by second camera 10 provides information about the depth of the substrate, and an illustrative example of such an image is schematically shown in FIG. 1B. The kerf 14 can clearly be seen extending from top to bottom of the image, where transmission through the substrate is increased due to the amount of material removed at the kerf. With such an image, the width of the kerf 14 is straightforward to determine. It should be noted that while FIG. 1B does not show any influence from the devices 3, information concerning these devices 3 may be obtainable from the image if the field of view is sufficiently large.

Efficiency is improved by simultaneously illuminating the first surface 2A of the substrate 2, the second surface 2B of the substrate, and imaging light received from the substrate, especially if these steps are performed during cutting of the substrate.

The alignment of the substrate 2 may be determined and controlled in a number of ways. For example, UV light imaged by first camera 9 may be analysed to determine the alignment, since the devices 3, which are on the upper surface of the substrate 2, will be visible in this image. As such, the devices 3 act as references for the substrate position. As an alternative, the IR light imaged by second camera 10 may be used for alignment, since the presence of devices 3 will be noticeable within this image. Here again, the devices 3 act as references for the substrate position. As a further alternative, alignment may be determined based on information obtained both from the UV image and the IR image, with one image providing corroboration and back-up for the other.

The information obtained from both UV and IR images is processed by the control means. The level of information obtained from both is sufficient to enable sufficient analysis "on the fly", i.e. during the cutting operation. Kerf position, kerf width (at the bottom of the kerf) and dicing depth can all be measured on the fly. Feedback may be provided so that the cutting operation is adjusted in dependence on the information obtained. Operational parameters controllable in this way may include, for example, stage speed, cutting power, focusing, control of any diffractive optical elements (DOEs) or active optical elements used.

Once a substrate has been cut, a new substrate enters the cutting apparatus for processing.

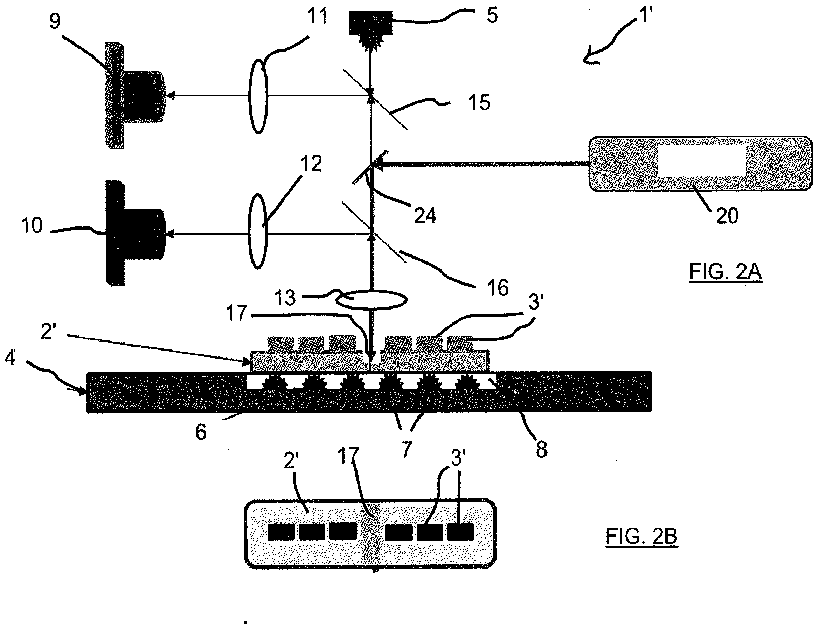

A second embodiment of the present invention is schematically shown in FIGs. 2A and 2B, which respectively schematically show an inspection system 1' for use during a grooving operation, and a camera image taken during the grooving operation. FIG. 2A is a part-sectional view, in which grooving of the substrate occurs along the axis normal to the plane of the paper.

It will be apparent that this second embodiment shares many similarities to that of the first embodiment, and so like reference numerals are retained wherever possible. Indeed, the same inspection system as shown in FIG. 1A may be used with a grooving operation. The key difference is that the cutting apparatus is here configured to create a relatively broad groove 17 within the substrate 2'.

Using the present inspection system 1' during the grooving process enables groove position, width and depth to be measured 'on the fly'. In addition, alignment processing may be performed in a similar way as for the first embodiment, due to the visibility of devices 3' in both UV and IR images.

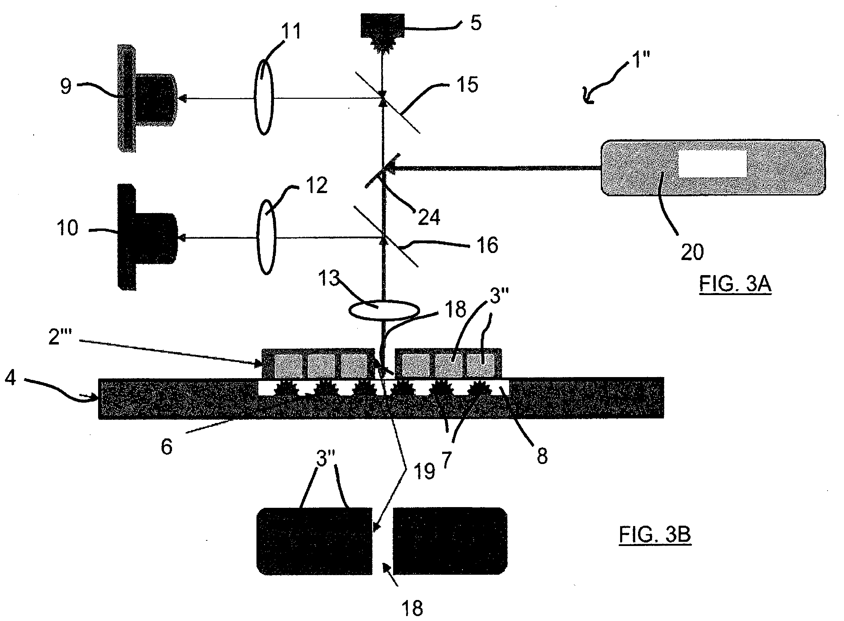

A third embodiment of the present invention is schematically shown in FIGs. 3A and 3B, which, respectively schematically show an inspection system 1" for use during a mold dicing operation, and a camera image taken during the mold dicing operation. FIG. 3A is a part-sectional view, in which dicing of the substrate occurs along the axis normal to the plane of the paper.

It will be apparent that this third embodiment shares many similarities to that of the first and second embodiments, and so like reference numerals are retained wherever possible. Indeed, the same inspection systems as shown in FIGs. 1A and / or 2A may be used with a mold dicing operation. In a mold dicing operation, a substrate 2" is processed, the substrate 2" having a number of devices 3" positioned thereon, which devices 3" are encased in a mold compound material 19, as is known in the art. With this type of process, the wavelength range selected for second illumination source 6 must be suitable for transmission through the mold compound material 19 in question. Suitable wavelengths are set out in Table 1 above.

As can be seen from FIG. 3B, the mold dicing cut 18 is clearly visible as being a region with maximum IR transmission. The cut 18 is bounded by regions of reduced transmission, which correlate to regions of remaining mold compound 19. Therefore it is apparent that the position of both kerf and remaining mold compound can be measured 'on the fly'. With a mold dicing process it may be impossible to provide alignment by using the reflected UV image, since the devices 3" are encased within the mold compound material 19, obscuring their visibility. However, alignment may still be performed using the transmitted IR image, since transmission will be less obstructed by devices 3" than by surrounding areas of mold compound 19, thus rendering the devices 3" visible in the image.

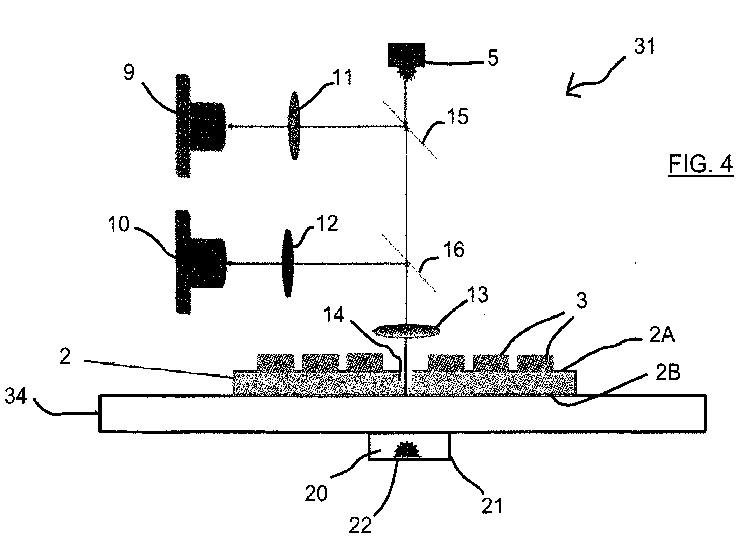

A fourth embodiment of the present invention is schematically shown in FIG. 4, which is a part-sectional view, in which dicing of the substrate 2 occurs along the axis normal to the plane of the paper. It will be apparent that this fourth embodiment shares many similarities to that of the first embodiment, and so like reference numerals are retained wherever possible. In this figure, the laser cutting equipment is omitted for clarity, but would still be present.

In this embodiment, the inspection system 31 comprises a second illumination source 20 which is mounted within a support 21 external to and below the chuck or stage 34. Here, the second illumination source 20 comprises a single IR source 22 to provide IR illumination, rather than an array of individual sources. Since with this embodiment the source 22 is spaced from the substrate 2, heating effects are not so pronounced or problematic, and so a single source 22 may be used. The source 22 is mounted so as to emit light in a generally vertically upward direction, towards the stage 34. So that light may penetrate through the stage 34, and hence illuminate the second side 2B of the substrate 2 following transmission through the stage 34, the stage is formed from a transparent or at least translucent material, such as glass or plastics material. Otherwise, the operation of the inspection system 31 is similar to that of the first embodiment.

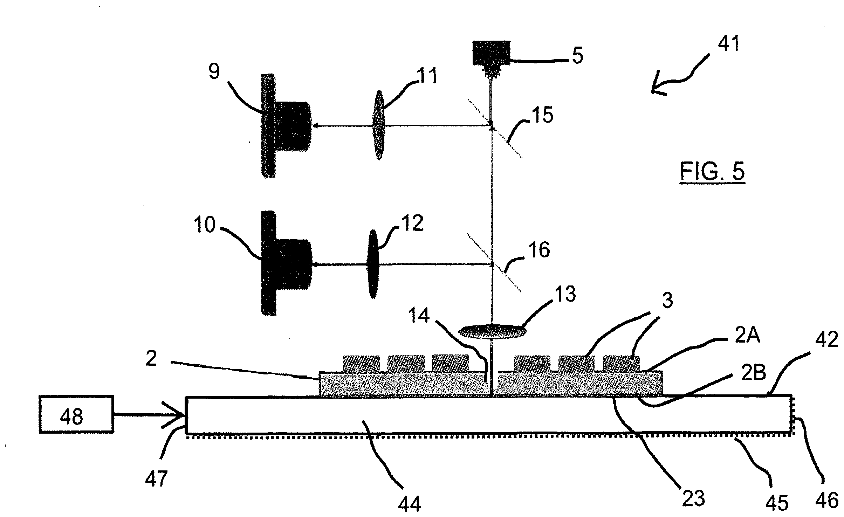

A fifth embodiment of the present invention is schematically shown in FIG. 5, which is a part-sectional view, in which dicing of the substrate 2 occurs along the axis normal to the plane of the paper. It will be apparent that this fifth embodiment shares many similarities to that of the first embodiment, and so like reference numerals are retained wherever possible. In this figure, the laser cutting equipment is omitted for clarity, but would still be present. This embodiment has an advantage over that of FIG. 4 in that it enables a limited head load.

In this embodiment, inspection system 41 comprises a chuck or stage 44 having a transparent or at least translucent body, such as a glass or plastics body for example. The stage body has an upper surface 42 for mounting a substrate 2 thereon. A lower surface 45 of the stage 44, being the side parallel and opposite to the upper surface 42 and substrate 2 in use, is mirrored, for example by applying a silvering coating, so that the lower surface 45 is made at least partially internally reflective to light, at least to the wavelengths of light emitted by the second illumination source. Similarly, the sidewalls 46 of the stage 44, being those walls orthogonal to the lower surface 45, are also mirrored in this way. However, a non-mirrored area 47 is retained on a first sidewall, forming a "window". The dimensions of this area 47 may be selected according to the application, but in this embodiment as shown in FIG. 5 extends the entire height and width of the left-most sidewall as shown. Area 47 is provided so that light from a illumination source acting as the second illumination source, in this case an IR laser 48, may enter the stage 44 through the area 47. The mirrored surfaces 45, 46 cause at least some of any incident light from laser 48 to be internally reflected. Scattering within the stage 44 will cause the light eventually to exit from the top of the stage, with at least some of this light being incident upon, and transmitted through, substrate 2. The transmitted light is imaged by camera 10 in a similar way as in the first embodiment.

It will be appreciated that since the stage 44 moves during the cutting operation, it is necessary to ensure that light from the laser 48 remains aimed at the area 47 throughout the operation. The laser 48 may therefore be mounted to the stage 44 for movement therewith, or alternatively the laser 48 could be statically mounted, and an optical direction system provided to ensure that the beam emitted therefrom follows the travel of the stage. This may be achieved for example by using a network of mirrors which are movable laterally to follow the stage, or rotatable to direct the beam towards the stage. As an alternative, a flexible optical fiber may be optically and mechanically connected between the laser 48 and area 47. Other directional optical networks will be apparent to those skilled in the art.

In alternative embodiments (not shown) using similar techniques, only the bottom surface of the stage may be mirrored, with all sidewalls remaining open to transmission. Depending on the dimensions of the stage, the majority of light may still exit through the upper surface of the stage.

The above-described embodiments are exemplary only, and other possibilities and alternatives within the scope of the invention will be apparent to those skilled in the art. For example:
- a single IR source may be used within a non-transparent / translucent stage, if the heating effect of the source is sufficiently low;
- an array of IR sources may be provided within a support external to and below the stage, if a transparent / translucent stage is used;
- the first illumination source need not emit UV light, but could for example emit other wavelength light, for example green or IR light;
- the second illumination source need not emit IR light, but could for example emit broad-band light. In the case that broad-band illumination is used, a suitable filter may be applied in the broad-band optical path, just before the camera, to increase the signal-to-noise ratio;
- depending on the wavelengths used by the first and second illumination source, a single camera may replace the first and second cameras described above. Such a camera must be able to distinguish between light received from the first and second illumination source;
- while the above-described embodiments all use laser-cutting equipment, the present inspection system may also be used with mechanical-cutting equipment;
- the present invention is equally applicable to other processes, e.g. which do not include cutting, where there is a non-constant light absorption profile. Suitable processes may include void detection in molded samples or crack detection in a silicon substrate for example.

### List of referenced components:

1, 1', 1", 31, 41 - inspection system
2, 2', 2" - substrate / wafer
5 2A - first surface of the substrate
2B - second surface of the substrate
3, 3', 3" - devices
4, 34, 44 - stage / chuck
5 - first illumination source
10 6, 20 - second illumination source
7 - individual LEDs
8 - cavity
9 - first camera
10 - second camera
15 11 - first imaging lens
12 - second imaging lens
13 - focusing lens
14 - kerf
15 - first beam splitter
20 16 - second beam splitter
17 - groove
18 - mold dicing cut
19 - mold compound material
20 - cutting laser
25 21 - support
22 - IR source
23 - dicing tape
24 - laser mirror
42 - upper surface of stage body
45, 46 - mirrored surfaces
47 - non-mirrored area
48 - laser input

## Claims

1. An inspection system for inspecting a substrate, the substrate being substantially planar and having first and second major surfaces on opposite sides thereof, the inspection system comprising:
a stage for supporting the substrate in use,
a first illumination source arranged to illuminate the first surface of the substrate supported by the stage in use,
a second illumination source arranged to illuminate the second surface of the substrate supported by the stage in use, and
at least one camera adapted to image light received from the substrate when it is illuminated by the first illumination source and/or the second illumination source.

2. An inspection system according to claim 1, comprising first and second cameras, the first camera being positioned to receive light from the first illumination source reflected from the first surface and the second camera being positioned to receive light from the second illumination source transmitted through the substrate, optionally the first and second cameras are both positioned on the first side of the substrate.

3. An inspection system according to claim 1, wherein the first and second illumination source are arranged to emit light at respective frequency ranges, the first and second frequency ranges being non-identical.

4. An inspection system according to claim 1, wherein the stage is transparent or translucent, optionally the second illumination source is arranged externally to the stage, such that it illuminates the second surface of the substrate following transmission of its emitted light through the stage, optionally the stage comprises an upper surface on which the substrate is supported in use, and a lower surface, opposite the upper surface, which lower surface is internally reflective to light from the second illumination source.

5. An inspection system according to claim 4, wherein the stage comprises at least one sidewall which is internally reflective to light.

6. An inspection system according to claim 4, wherein the second illumination source is operative to illuminate a side portion of the stage in use, optionally the second illumination source comprises a laser, optionally the inspection system comprises an optical direction system operative to guide light emitted from the second illumination source to the side portion in use.

7. An inspection system according to claim 1, wherein the second illumination source is mounted within the stage.

8. An inspection system according to claim 7, wherein the stage comprises:
a surface for supporting the substrate thereon in use,
a cavity within the stage,
wherein the second illumination source is mounted within the cavity such that light emitted by the second illumination source escapes the cavity and is incident upon the substrate in use.

9. An inspection system according to claim 8, wherein the surface comprises a transparent window on a first side of which the substrate is supported in use, the cavity being located adjacent a second side of the window, opposite to the first side.

10. An inspection system according to claim 8, wherein the surface comprises an opening below the supported substrate in use, the opening leading to the cavity.

11. An inspection system according to claim 1, wherein the second illumination source comprises an array of light sources, optionally the light sources of the array are individually controllable.

12. Substrate cutting apparatus comprising an inspection system of claim 1 and a substrate cutting means, optionally the substrate cutting means comprises a laser cutter, optionally the substrate cutting apparatus comprises control means for controlling the laser cutter, the control means operable to receive image information from the first and second cameras and control the laser cutter in dependence of the received image information.

13. A method of inspecting a substrate, the substrate being substantially planar and having first and second major surfaces on opposite sides thereof, the method comprising the steps of:
i) illuminating the first surface of the substrate,
ii) illuminating the second surface of the substrate, and
iii) imaging light received from the substrate.

14. A method according to claim 13, wherein step iii) comprises using first and second cameras to image the received light, the first camera being positioned to receive light from a first illumination source reflected from the first surface and the second camera being positioned to receive light from a second illumination source transmitted through the substrate, and optionally step ii) comprises illuminating at least an area of a sidewall of a transparent or translucent stage on which the substrate is supported.

15. A method according to claim 13, wherein step i) comprises illuminating the first surface of the substrate with light at a first frequency range, step ii) comprises illuminating the second surface of the substrate with light at a second frequency range, and wherein the first and second frequency ranges are non-identical.

16. A method according to claim 13, further comprising the step of:
iv) aligning the substrate using received light from the illumination performed in step ii).

17. A substrate cutting process comprising performing the substrate inspection method of claim 13.
